# EUROPÄISCHE PATENTSCHRIFT

(11) **EP 0 984 527 B1**
(45) Veröffentlichungstag und Bekanntmachung des Hinweises auf die Patenterteilung: **04.06.2003**
(21) Anmeldenummer: 99116505.1
(22) Anmeldetag: 23.08.1999
(51) Int. Cl.: H01R 13/74, F16B 21/08, F16B 5/06, F16B 19/10

(54) **Bauteil aus Kunststoff mit einem Spreizniet zur spielfreien Befestigung auf einer gelochten Platte**
Plastic component with a fastener with a stud for mounting without play on a plate with holes
Piece en matière plastique avec une agrafe à étrésillon pour monter sans jeu sur une plaque perforée

(30) Priorität: 02.09.1998 DE 19840014
(43) Veröffentlichungstag der Anmeldung: 08.03.2000
(73) Patentinhaber: Tyco Electronics Logistics AG, 9323 Steinach / SG (CH)
(72) Erfinder: Spielvogel, Michael, 67098 Bad Dürkheim (DE)
(74) Vertreter: Klunker . Schmitt-Nilson . Hirsch

(56) Entgegenhaltungen:
- US-A- 5 259 689

## Beschreibung

Bauteil aus Kunststoff mit einem Spreizniet zur spielfreien Befestigung auf einer gelochten Platte

Die Erfindung betrifft einen Spreizniet aus Kunststoff entsprechend dem Oberbegriff nach Anspruch 1 (US 5 259 689 A).

Ein derartiges Bauteil mit Spreizniet ist auch beispielsweise aus der DE-OS 2 221 841 bekannt. Nieten, insbesondere Spreiznieten, dienen bekanntlich zum Herstellen einer nichtlösbaren Verbindung zweier Bauteile, wobei die Kraftübertragung primär durch Formschluß zustande kommt. Einstückig angeformte Kunststoff-Spreizniete werden in Löcher der Montageplatte eingesteckt, woraufhin durch Einschlagen bzw. Eindrücken des Spreizdorns der segmentierte Schaft des Nietes auseinandergetrieben wird, so daß dieser in der Montageplatte fixiert wird.

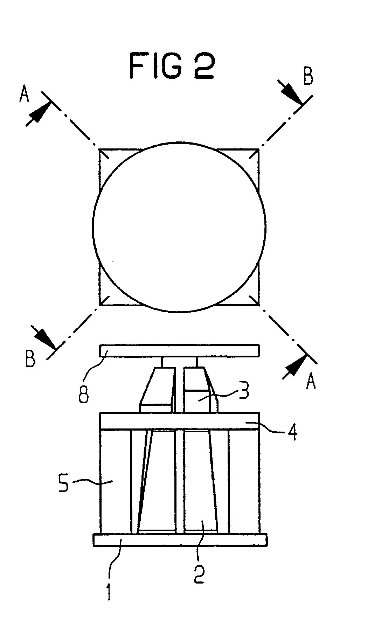

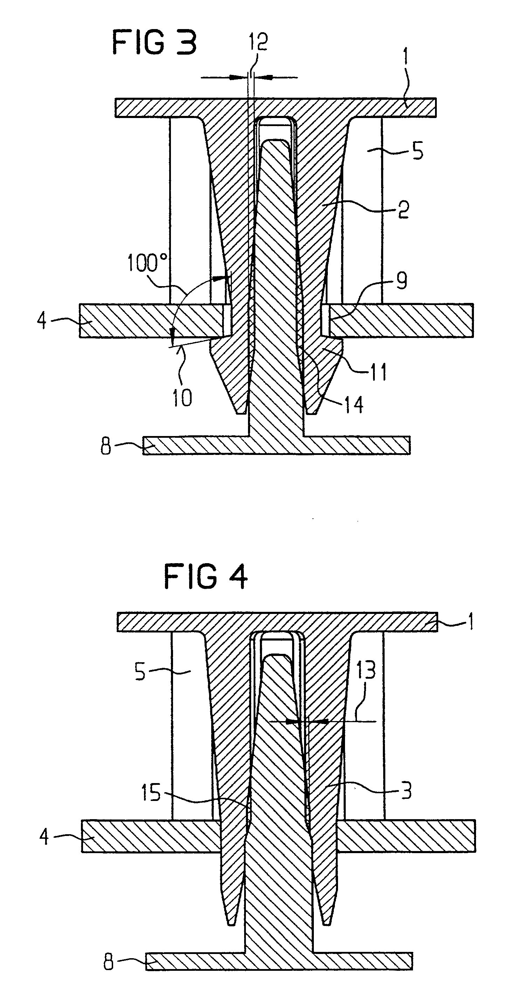

In der Schnittdarstellung der Figur 2 der genannten Offenlegungsschrift sind die durch den eingedrückten Spreizdorn aufgefächerten Nietbackensegmente erkennbar, die schräg nach unten, sich dabei aufweitend, aus dem Montageloch herauslaufen. Typisch für die bekannten Spreiznieten ist dabei, daß ein gewisser, aber nicht sehr großer Hinterschnitt zwischen dem unteren Ende der Nietbacken und der Lochleibung auftritt, sowie ein Haltewinkel (vgl. die genaue Definition in Figur 3 der vorliegenden Anmeldung), der etwa in der Mitte zwischen 90° und 180° liegt. Dieser bekannte Aufbau ist für eine spielfreie Verbindung, die sowohl in axialer wie in radialer Richtung maximale Kräfte aufnehmen können sollte, aus folgenden Gründen nicht ideal:

Die Übertragbarkeit von axialen und radialen Kräften von Speiznietverbindungen ist im wesentlichen durch den Haltewinkel des Hinterschnitts bestimmt. Maximale axiale Haltekraft würde hierbei bei einem Winkel von 90° erreicht werden. Da Toleranzen in der Dicke der gelochten Platte zu berücksichtigen sind, kommen jedoch nur Haltewinkel zwischen 90° und 180° in Frage. Außerdem müßte zum Ausgleich von Toleranzen in der Lochleibung Spiel gelassen werden, so daß bei einem Haltewinkel von 90° die radiale Übertragbarkeit Null wäre. Umgekehrt verschwindet die axiale Übertragbarkeit bei einem Haltewinkel von 180°. Die Reibkraft, die dann zwar noch axial wirkt, hängt von der Normalkraft zwischen Spreiznietbacke und Lochleibung ab und geht bei der Forderung, die Verbindung gerade spielfrei einzustellen, gegen Null.

Ein üblicherweise realisierter Kompromiß zur Verbindung der beiden Übertragungseigenschaften der Verbindung ist deshalb ein Haltewinkel zwischen 90° und 180°. Hierbei ergibt sich die jeweilige Haltekraft in axialer und radialer Richtung als Komponente der Normalkraft auf die Haltefläche. Entscheidend ist, daß dadurch beim bekannten Spreizniet eine maximale Übertragbarkeit in beide Richtungen gleichzeitig prinzipiell nicht erreicht werden kann. Im übrigen ist auch problematisch, daß die Berührung zwischen Nietbacken und Lochleibung eine Linienberührung ist, was zu örtlich hoher Flächenpressung und Versagen der Verbindung durch plastisches Verformen des Nietmaterials führen kann. Beim Auslösen der Nietverbindung kann außerdem aufgrund der Reibkraftanteile zwischen Spreizbacke und Loch eine undefinierte Lage der Platte gegenüber der Auflage entstehen.

Die Aufgabe der vorliegenden Erfindung besteht in der Schaffung verbesserter Bauteile der eingangs genannten Art, welche, ohne viel Bauraum zu beanspruchen, langfristig die Aufnahme maximaler axialer und radialer Kräfte gewährleisten. Außerdem soll bei der Montage sichergestellt sein, daß die Platte zunächst axial fixiert wird und somit gegen die Auflage gedrückt wird, bevor der radiale Formschluß hergestellt wird.

Diese Aufgabe wird bei einem Bauelement der eingangs genannten Art dadurch gelöst, daß die vier Nietbacken-Segmente in zwei in axialer Richtung und zwei in radialer Richtung formschlüssig wirkende Nietbacken-Segmente aufgeteilt sind, daß die axial wirkenden Nietbacken-Segmente als Schnapphaken mit einem Haltewinkel von etwa 100° ausgeführt sind, und daß an den Nietbacken-Segmente Mittel vorgesehen sind, durch die beim Auslösen der Nietverbindung durch Eindrücken eines Spreizdorns zuerst die axialen und danach die radialen Nietbacken-Segmente auslösen.

Weitere Ausführungsformen der Erfindung sind in Unteransprüchen gekennzeichnet.

Anhand der Figuren der Zeichnung wird im folgenden ein Ausführungsbeispiel eines erfindungsgemäßen Bauteils näher erläutert. Es zeigen:
- Figur 1: in perspektivischer Ansicht ein erfindungsgemäßes Bauteil mit Spreizniet, darüber eine gelochte Platte und darüber einen nicht eingedrückten Spreizdorn,
- Figur 2: eine Seitenansicht des Ensembles gemäß Figur 1 in ausgelöstem Zustand,
- Figur 3: einen seitlichen Schnitt A - A gemäß Figur 2,
- Figur 4: einen seitlichen Schnitt B - B gemäß Figur 2,
- Figur 5: eine Draufsicht auf ein erfindungsgemäß gestaltetes Gehäusebauteil mit Spreiznieten.

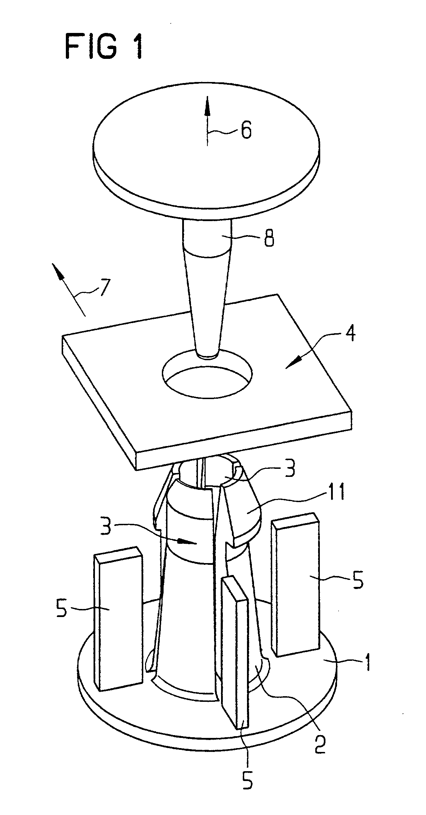

In Figur 1 sind der Kunststoffträger 1 mit dem einstückig angeformten, insgesamt konisch nach oben zulaufenden Rotationskörper des Spreizniets mit seinen zwei, einander jeweils gegenüberstehenden, Axial-Segmenten 2 und seinen zwei ebenso gegenüberstehenden Radial-Segmenten 3 erkennbar. Als Auflage für die gelochte Platte 4, also zur Fixierung in einer ersten Axialrichtung, dienen hier beispielsweise am Kunststoffträger 1 angeformte Säulen 5. Die axiale und die radiale Wirkrichtung sind durch Pfeile 6,7 angedeutet.

In Figur 2 ist die ausgelöste Spreizniete mit eingedrücktem Spreizdorn 8 dargestellt. In diesem ausgelösten Zustand sind die Komponenten Spreizdorn 8, Platte 4 und Kunststoffträger 1 mit Spreizniete starr miteinander verbunden. Die Spreizniete verbindet also die Platte 4 mit einem festen Teil 1.

In Figur 3 ist zunächst zu erkennen, daß die Nietbacken-Segmente 2 auch bei ausgelöstem, das heißt eingedrücktem Spreizdorn 8 in der Lochleibung 9 noch ein gewisses seitliches Spiel haben. Als Haltewinkel 10 wurde, wie dargestellt, 100° gewählt, also eine nur geringe Überschreitung des für die axiale Übertragbarkeit idealen Winkels von 90°. Diese Abweichung, das heißt der Haltewinkel 10 von etwa 100°, dient lediglich zum Ausgleich der Dickentoleranz der Platte 4, die Überschreitung des Haltewinkels 10 von 90° soll so gering sein, daß die Hauptwirkrichtung praktisch rein axial bleibt. Die Enden der Nietbacken-Segmente 2 sind als Schnapphaken 11 ausgebildet.

In Figur 4 ist erkennbar, daß die radiale Kraftkomponente durch das in Schnitt B - B gemäß Figur 2 dargestellte Profil, also die in radialer Richtung wirkenden Nietbacken-Segmente 3 aufgenommen wird.

Die Nietverbindung wird durch einen Spreizdorn 8 ausgelöst, der so dimensioniert wurde, daß die Verbindung in axialer und radialer Richtung gerade spielfrei ist. Aufgrund der auszugleichenden Toleranzen ist beim axial wirkenden Segment 2 ein Weg 12 von maximal 0,25 mm erforderlich, beim radial wirkenden Segment 3 ein Weg 13 von maximal 0,15 mm. Bei ungünstiger Toleranzlage ergibt sich für das axiale Segment 2 nach Einstellung der Spielfreiheit ein Restüberschnitt zwischen Nietdorn 8 und Platte 4 von 0,15 mm, der durch die Verformung des Segmentes 2 aufgenommen wird. In Figur 3 ist die Verformung des Segmentes 2 nicht real dargestellt; tatsächlich verformt sich das Segment 2 und nicht, wie dargestellt, der Spreizdorn 8. Bei dem radial wirkenden Segment 3 beträgt dieser Überschnitt 0,15 mm.

Die erfindungsgemäße Verbindung zwischen dem Kunststoffträger 1 und der gelochten Platte 4 überträgt in axialer und radialer Richtung die maximal mögliche Kraft. Die Berührung zwischen Platte 4 und Nietbacken 2,3 ist in beiden Richtungen quasi flächig, wodurch eine hohe Funktionssicherheit erreicht wird. Die erfindungsgemäße Entkopplung von axialer und radialer Richtung hat außerdem zur Folge, daß über den Weg des Spreizdorns 8 die Auslösereihenfolge eingestellt ist. Zunächst werden die axial wirkenden Segmente 2 ausgelöst, wodurch ein Niederdrücken gegen die Auflage 5 erreicht wird. Erst danach, beim weiterem Eindrücken des Nietdorns 8,lösen die radialen Segmente 3 aus. Dies kann beispielsweise durch ein Zurückversetzen der Auslösefläche 15 der radialen Segmente 3 gegenüber der Auslösefläche 14 der axialen Segmente 2 erreicht werden, vgl. Figuren 3 und 4. Insgesamt bleibt dadurch die Position der Platte 4 im Montagezustand definiert.

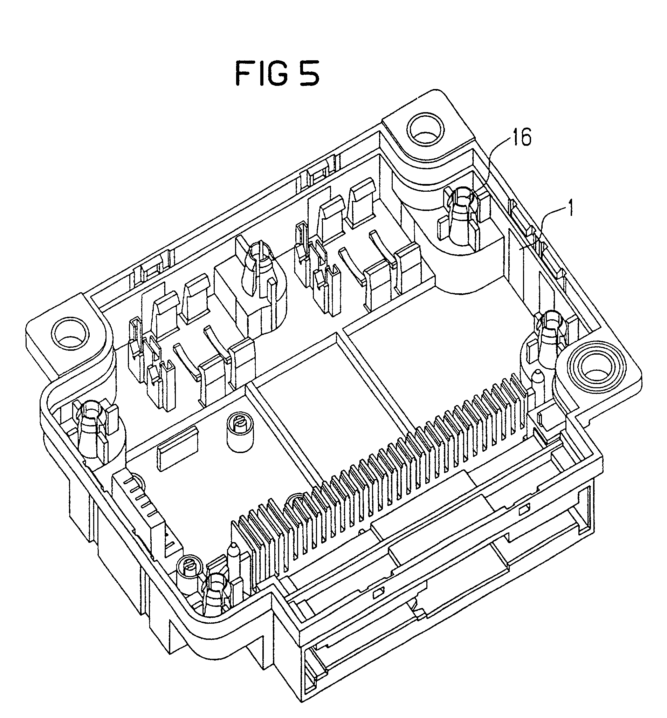

In Figur 5 ist zur weiteren Erläuterung ein Kunststoffgehäuse 1, hier insbesondere für ein Airbagsteuergerät dargestellt, an das fünf Spreiznieten 16 angeformt sind. Die wesentlichen Schaltungsteile des Steuergeräts können sich auf einer Leiterplatte befinden, auf der fünf Löcher für die Spreiznieten 16 vorgesehen sind, so daß sie mit ihrer Rückseite nach oben auf den Spreiznieten 16 angeordnet werden kann. Anschließend kann das Gehäuse 1 beispielsweise mit einer Bodenplatte (nicht dargestellt) verschlossen werden, an der fünf nach innen ins Gehäuse ragende Spreizdorne angeformt sind, so daß bei der Montage der Bodenplatte alle fünf Spreiznieten 16 gleichzeitig ausgelöst werden.

## Patentansprüche

1. Spreizniet (16) aus Kunststoff, der mit einem Kunststoffträger (1) einstückig verbunden ist und zur spielfreien Befestigung auf einer gelochten Platte (4) vorgesehen ist, wobei ein Rotationskörper am Spreizniet (16) vorgesehen ist, der in vier Nietbacken-Segmente gespalten ist,
**dadurch gekennzeichnet,**
- **daß** die vier Nietbacken-Segmente (2,3) in zwei in axialer Richtung und zwei in radialer Richtung formschlüssig wirkende Nietbacken-Segmente (2,3) aufgeteilt sind,
- **daß** die axial wirkenden Nietbacken-Segmente (2) als Schnapphaken (11) mit einem Haltewinkel (10) von etwa 100° ausgeführt sind,
- und **daß** an den Nietbacken-Segmenten (2,3) Mittel vorgesehene sind, durch die beim Auslösen der Nietverbindung durch Eindrücken eines Spreizdorns (8) zuerst die axialen und danach die radialen Nietbacken-Segmente (2,3) auslösen.

2. Elektrisches Bauteil mit Spreizniet nach Anspruch 1,
**dadurch gekennzeichnet,**
**daß** die Auslösefläche (15) an den Innenseiten der Nietbacken der radial wirkenden Segmente (3) gegenüber der Auslösefläche (14) an den Innenseiten der Nietbacken der axial wirkenden Segmente (2) soweit zurückversetzt angeordnet ist, daß über den Weg des Spreizdorns (8) beim Eindrücken die Auslösereihenfolge der Nietbacken-Segmente (2,3) eingestellt ist.

3. Verwendung des Bauteils nach Anspruch 1 oder 2 zur Bestükkung bzw. zur Umhäusung von gedruckten Schaltungsplatten.

## Claims

1. An expansion rivet (16) of plastics, which is connected in one piece with a plastics support (1) and is provided for play-free fastening to a perforated plate (4), wherein a rotational body is provided on the expansion rivet (16) which is split into four rivet jaw segments,
**characterised in that**
the four rivet jaw segments (2, 3) are divided into two rivet jaw segments (2) acting interlockingly in the axial direction and two rivet jaw segments (3) acting interlockingly in the radial direction,
the axially acting rivet jaw segments (2) take the form of snap-action hooks (11) with a retaining angle (10) of approximately 100°,
and there are provided on the rivet jaw segments (2, 3) means by which firstly the axial and then the radial rivet jaw segments (2, 3) are set when the rivet connection is set by pushing in of an expansion mandrel (8).

2. An electrical component with expansion rivet according to claim 1,
**characterised in that**
the setting surfaces (15) on the inner sides of the rivet jaws of the radially acting segments (3) are set back so far relative to the setting surfaces (14) on the inner sides of the rivet jaws of the axially acting segments (2) that the setting sequence of the rivet jaw segments (2, 3) is established over the path of the expansion mandrel (8) when it is pushed in.

3. Use of the component according to claim 1 or 2 for assembling or encasing printed circuit boards.

## Revendications

1. Rivet d'expansion (16) en plastique, relié d'une seule pièce avec un support en plastique (1) en vue d'une fixation sans jeu sur une plaque perforée (4), le rivet d'expansion (16) comportant un corps rotatif, séparé en quatre segments de mâchoire de rivet,
**caractérisé en ce que**
les quatre segments de mâchoire du rivet (2, 3) sont subdivisés en deux segments de mâchoire de rivet agissant par engagement positif dans la direction axiale et deux segments correspondant agissant par engagement positif dans la direction radiale (2, 3)
les segments de mâchoire du rivet agissant dans la direction axiale (2) ont la forme de crochets à encliquetage (11) avec un angle de retenue (10) d'environ 100°,
les segments de mâchoire du rivet (2, 3) comportent des moyens actionnant d'abord les segments de mâchoire du rivet à action axiale et ensuite les segments à action radiale (2, 3) lors de l'établissement de l'assemblage par rivet par enfoncement d'un mandrin d'expansion (8).

2. Composant électrique comportant un rivet d'expansion selon la revendication 1,
**caractérisé en ce que** la surface d'actionnement (15) sur les côtés internes des mâchoires du rivet des segments à action radiale (3) sont décalées vers l'arrière par rapport à la surface d'actionnement (14) sur les côtés internes des mâchoires du rivet des segments à action axiale (2), de sorte à ajuster l'ordre d'actionnement des segments des mâchoires du rivet (2,3) par l'intermédiaire de la course du mandrin d'expansion (8) lors de son enfoncement.

3. Utilisation du composant selon les revendications 1 ou 2 pour équiper ou pour renfermer des cartes de circuit imprimé.
